# EUROPEAN PATENT APPLICATION

(11) **EP 1 703 566 A1**
(43) Date of publication of application: **20.09.2006**
(21) Application number: 05447061.2
(22) Date of filing: 18.03.2005
(51) Int. Cl.: H01L 29/78

(54) **MOS device having at least two channel regions**

(71) Applicant: AMI Semiconductor Belgium BVBA, 9700 Oudenaarde (BE)
(72) Inventor: Moens, Peter, B-9620 Zottegem (NL)
(74) Representative: Bird, William Edward

(57) **Abstract**

A multi cell power semiconductor device has a gate (poly, 220), a source region (N+) and a drain region (BLN), a drift region (240) between the source and drain, and two or more channel regions (200, 210) arranged to allow current flow in parallel between the source and drain. Two channel regions in parallel helps allow a greater maximum current density for a given reverse blocking voltage, so ON resistance can be reduced, without decreasing the reverse breakdown voltage. One channel can be vertical, and one can be predominantly lateral, to enable better integration. The gate region can be a deep trench structure. The device can be symmetrical having a pair of source regions, and a pair of second gate regions, and a pair of lateral channels and a pair of vertical channels.

## Description

### Field of the invention:

This invention relates to semiconductor devices having multiple channels, and to multi cell devices having such devices as well as methods of manufacture and of operating the same.

### Description of the Related Art:

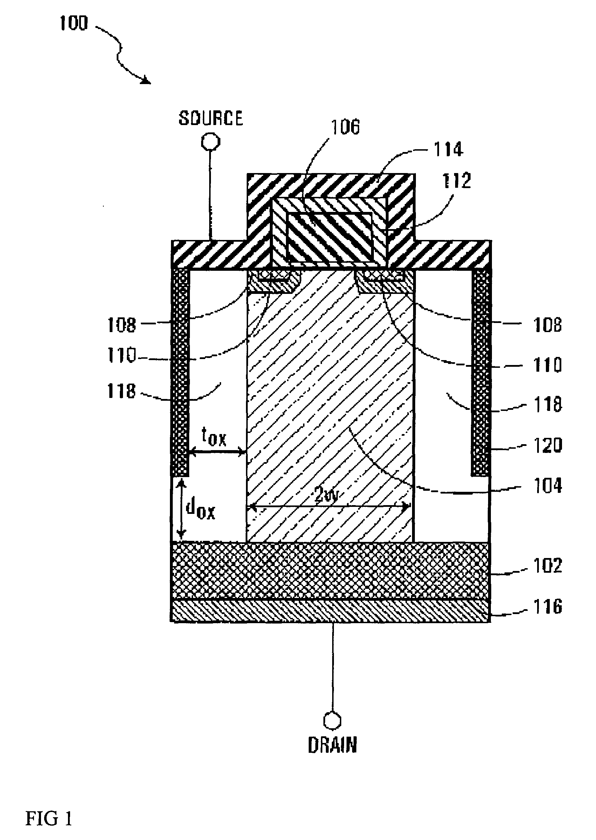

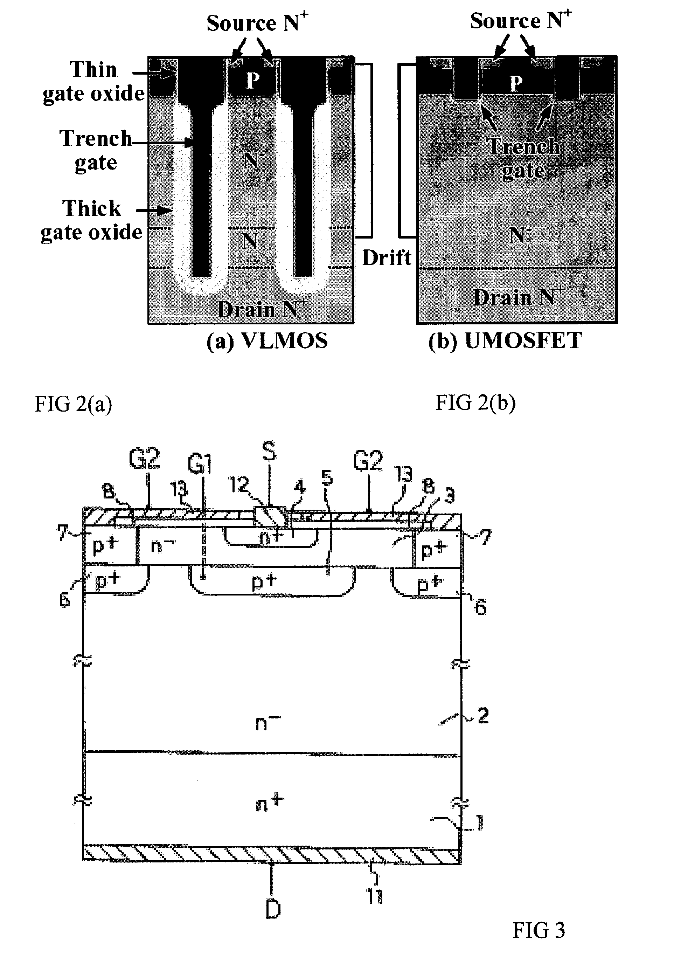

In Power MOSFET devices, the resistance (and therefore power loss) contributions may be associated with the contacts, the substrate, the channel, the accumulation region and the drift region. In general, the drift region and the channel are the two dominant components of a power VDMOS (vertical double diffused MOS) ON-resistance. They are followed by the substrate and the accumulation region.
Various different directions have been explored to reduce the contribution to the ON - resistance of either of these regions: In EP 1,302,987 A1, the threshold voltage of the vertical trench gated MOSFET is reduced by implanting cesium into the gate oxide layer. The cesium in the bottom oxide acts as a positive charge which improves the accumulation region and thereby lowers the on-resistance of the device.
In UMOS or trenchMOS (UMOS refers to the U- shape of the trench) devices, the smaller cell size allows for an increase in channel density and hence a decrease in the specific ON resistance (as a larger number of channels act in parallel). This is shown by B. Jayamt Baliga and Dev Alok Girdhar, "Paradigm Shift in Planar MOSFET Technology", Power Electronics Technology, November 2003. It is known that in conventional semiconductor power devices, any reverse voltage applied across the n+ - region(s) and p+-region(s) is sustained by a lightly doped semiconductor layer, called hereafter a drift layer. For high voltage power devices, the on-resistance is also dominantly determined by the drift layer. The breakdown voltage mainly depends on the doping concentration and the thickness of this drift layer. The lower the concentration is and/or the larger the thickness is, the higher the breakdown voltage is, but the larger also the on-resistance is. One of the most important problems of many power devices, especially of devices such as VVMOS, VDMOS and UMOS, is to get both high breakdown voltage and low on-resistance. For example, in advanced power MOSFET, or UMOS, the voltage sustaining layer is an n+-epi-layer, the theoretical limit of the on-resistance in unit area Ron is Ron = 7.4 x 10⁻⁹V_{*B*}^{2.5} ['Ω.cm²]
It is also known to use superjunctions for high voltage transistors having low ON resistance. An early example is shown in US patent 5,216,275. Super-Junction MOS devices aim at reducing the resistance of the drift region by increasing its doping. This is possible without reduction of the holding voltage thanks to the so-called compensation or charge balanced structure described in US 5, 216,275.. This document shows a drift layer in the form of a composite buffer layer (CB-layer). The active region of the power devices is made just above this layer. Then, the restriction of R-ON versus V_{*B*} for the power devices is eased and this enables improved on-voltage and breakdown voltage. The CB-layer contains two kinds of regions with opposite types of conduction, i.e. n-regions and p-regions. These two regions of different conduction types are alternately arranged. The n-regions and the p-regions contribute charges with opposite signs, and the fields induced by them largely cancel each other out. The doping concentrations of the n-regions and the p-regions therefore can be much higher than that in the conventional drift layer. And, the on-resistance of the former is much lower. This arrangement has become known as a super junction.
It is also known from US patent 6693323 to refine such superjunctions. The n-type drift regions are heavily doped and the thickness of drift layer is reduced corresponding to the heavy doping, so that the ON-resistance of the vertical super-junction MOSFET can be reduced to 1/5 of the ON-resistance of a conventional vertical MOSFET. By further narrowing n-type drift regions and by further increasing the impurity concentration in n-type drift regions, the on-resistance and the tradeoff relation between the on-resistance and the breakdown voltage can be further reduced. This super-junction MOSFET differs from the conventional super-junction MOSFET in the way of forming drift layer (that is, the way of forming p-type partition regions and n-type partition regions) and the resulting drift layer structure. In more detail, since n-type drift regions and p-type partition regions are formed by diffusing respective impurity ions, impurity concentration distributions are caused in the drift layer.
It is also known from US patent 6353252 that in a high breakdown voltage semiconductor device, a drift region is divided into a plurality of long regions each interposed between a plurality of trenches, and a depletion layer expands in a drift region from an interface between the drift region and each of the trenches when a reversed bias is applied. Thus, the impurity concentration of the drift region can normally be increased without degrading the targeted breakdown voltage. Consequently, the on-resistance can be lowered by increasing the impurity concentration of the drift region. In this case the drain electrode is on the same side as the gate and source, but the flow of current is predominantly parallel to the surface of the chip, thus this is called a lateral structure, rather than a vertical structure.
It is also known from US patent application 2002/0195627 to provide a superjunction device with a 15 micron deep trench in place of a prior art 35 micron trench for a 600 volt device. A denser structure can be made, using a 1 micron pitch. Since pitch is proportional to ON-resistance R_{DSON} the reduction of pitch is very desirable. Since the device is a lateral conduction device, it will have a reduced gate charge Qg which is essential to many applications. The structure lends itself to the integration of plural devices in a common chip, for example, a bridge circuit can be integrated into a single chip. The device can act as a high side switch when the N layer is designed to support the rail voltage between source and substrate. High side devices, low side devices and control circuitry can then be integrated into the same silicon. Again the drain is on the same side as the source, but the current flow is predominantly parallel to the surface of the device.
Other variations have been tried. In Yung C. Liand et al, « Oxide bypassed VDMOS (OBVDMOS) : An Alternative to Superjunction High Voltage MOS Power Devices", IEEE Electron Devices Letters, Vol. 22. N0. 8, August 2001, an oxide bypass is shown. This is also shown in US 2003/0006453 A1, and includes an oxide layer then a metal layer at the sides of the drift region which is below a gate, as shown in figure 1. The document shows an oxide bypassed VDMOS relying on sidewall metal-thick-oxide instead of the p-columns used in earlier devices to bypass the field in the drift region. The thick oxide provides a region for sustaining high voltage while the field effect by the MTO electrode helps to deplete the n-column laterally. Hence the doping in the n-region can be raised.
"A simple Technology for Super-junction Device Fabrication: Poly-flanked VDMOSFET " Kin Paau Gan et al, IEEE Electron Devices Letters, Vol. 23. No. 10, October 2002, shows a thin oxide between the P and N columns in the drift region to reduce interdiffusion, and a poly flanked structure for edge termination.
"Tuneable Oxide-Bypassed Trench Gate MOSFET: Breaking the Ideal Super-junction MOSFET Performance Line at Equal Column Width" Xin Yang et al, IEEE Electron Devices Letters, Vol. 24. No. 11, November 2003 shows using a tunable oxide bypassed superjunction device to tune the off-state blocking capability to compensate for material and process variations.
"Temperature characteristics of a new 100V rated power MOSFET, VLMOS (Vertical LOCOS MOS)", Masahito Kodama et al, Proceedings of 2004 International Symposium on Power Semiconductor Devices & ICs, Kitakyushu, pp. 463-466, shows a structure with deep trench gates and local oxidation of silicon (LOCOS). Each trench gate has a thick insulator facing the drift region, and thin insulation adjacent to the channel, as shown in figure 2.
In US 6,600,192 B1 a buried gate G1 is provided as well as a surface gate, G2, as shown in figure 3. By applying a voltage that is equal to the built-in voltage or higher to the gate, holes are injected into the channel region from the buried gate and the ON-resistance is further reduced. There remains a need for improved devices.

### SUMMARY OF THE INVENTION

An object of the invention is to provide improved semiconductor devices having multiple channels, and to multi cell devices having such devices as well as methods of manufacture and of operating the same.
According to a first aspect, the invention provides:
a semiconductor device comprising a control electrode such as a gate, a first main electrode region such as a source region and a second main electrode region such as a drain region, a drift region between the first and second main electrode regions, e.g. between source and drain, and two or more channel regions arranged to allow current flow between the first and second main electrode regions, e.g. between source and drain. The current flows are in parallel, but the channels need not be. For example, one channel can be vertical, the other can be lateral i.e. they can be perpendicular to each other.
The semiconductor device can include any suitable transistor, e.g. MOS type such as MOSFET, a HV bipolar transistor, etc. For an HV bipolar transistor the gate 1 is replaced by a base contact. A combined MOS/bipolar transistor can also be used, e.g. for applications such as ESD.

The use of two channel regions in parallel helps allow a greater maximum current density for a given reverse blocking voltage. This means the ON resistance can be reduced. This can be achieved without decreasing at the same time the reverse breakdown voltage. It is useful for power devices in which high breakdown voltage and low ON resistance are particularly desirable.

An optional additional feature of the present invention is a first of the channels being predominantly vertical, and a second being predominantly lateral. This helps enable the channel regions to be accommodated in a small volume, to enable better integration.

A particular advantage of embodiments of the present invention is the combination of vertical and lateral channels. The vertical channel can be integrated along the trench sidewall and as such does not increase the pitch or the size of the device. However, it adds to the current density in the device and as such can decrease the specific on-resistance significantly, e.g. by a factor of 2 if the current density of the vertical channel equals the lateral channel, without degrading the breakdown voltage.

Another optional additional feature of the present invention is the control electrode region, e.g. the gate region, comprising first and second regions for each of the channels. This helps enable the channels to be separated.

Another additional feature is the first and second control electrode regions being separately controllable. This can help optimize each of the channel regions.

Optionally, the thickness of insulation for a control electrode such as a gate oxide thickness and the work function of the control electrode material such as polysilicon for both lateral and vertical channels are substantially or actually equal.

The present invention allows for variations in the channel design and thickness and selection of suitable threshold values Vt to obtain desired properties, e.g. if Vt of the first channel is lower than Vt of second channel, the lateral channel will conduct most of the current at low potential on the control electrode, i.e. gate-source voltage Vgs, which is advantageous for protection against hot carrier degradation. This can occur mainly at the birds beak i.e. along the vertical channel. For a large gate overdrive, both channels are active and contribute to the current. However, for large Vgs, the maximum electric field is pushed down to the drain (BLN), hence there is less risk for hot carrier degradation at the birds beak.

Another additional feature is the first control electrode region, e.g. the first gate region, comprising a surface gate structure. This can be easier to manufacture, is suitable for a lateral channel region, and helps keep the channels separate.

Another additional feature is the first main electrode region, e.g. the source region being arranged in between the first and second control electrode regions, e.g. the first and second gate regions. This can help keep the device more compact.

The work function of the control electrode material such as polysilicon for the control electrodes may be different, e.g. work function of the second gate can be different from the first gate. Also the gate insulating thickness for a first gate may be different than for a second gate.

Another such additional feature is the device having a symmetrical structure about the first control electrode region, e.g. the first gate region, having a pair of first main electrode regions, e.g. source regions, and a pair of second control electrode regions, e.g. second gate regions, and a pair of lateral channels and a pair of vertical channels. This can help enable a more compact device.

Another such additional feature is the drift region being arranged as a vertical common drift region coupled to all the channels.

Another aspect of the invention provides a multi cell semiconductor device having many unit cells, each unit cell comprising the above device.

Another feature is a main electrode contact such as the drain contact being at the bottom of the structure, for example an n+ substrate, as in discrete devices or can be a BLN that is contacted to the top semiconductor layer, e.g. silicon, via a sinker such as an N-sinker in order to allow integration.

Instead of a n+ substrate the present invention can be implemented on a p+ substrate with a p-type drift region.

Another feature is the use of trenched control electrodes such as trenched gates. Another feature is the use of dielectric in the trench. Depletion through a capacitor is obtained through a trench insulating layer, e.g. a trench oxide. If the trench oxide is replaced by a high k dielectric, e.g. nitride, oxi-nitride, HfO₂, the drift concentration can be increased even further as the field is related to the dielectric constant. Hence an even larger improvement can be expected.

Any of the additional features can be combined together and combined with any of the aspects. Other advantages will be apparent to those skilled in the art, especially over other prior art. Numerous variations and modifications can be made without departing from the claims of the present invention. Therefore, it should be clearly understood that the form of the present invention is illustrative only and is not intended to limit the scope of the present invention.

### BRIEF DESCRIPTION OF THE DRAWINGS

How the present invention may be put into effect will now be described by way of example with reference to the appended drawings, in which:
Figure 1 shows an oxide bypassed VDMOS called a super-MOS, as shown in US 2003/0006453,
Figures 2(a) and (b) show a known oxide recessed VDMOS and known UMOSFET respectively,
Figure 3 shows a Vertical Field-Effect Semiconductor Device with Buried Gate Region as shown in US 6,600,192,
Figure 4 shows an embodiment of the present invention, and
Figure 5 shows a graph of ON resistance in function of the number of cells for an OBVDMOS and for an embodiment of the invention (V_{BD} = 80V for both devices).

### DETAILED DESCRIPTION OF THE INVENTION

The present invention will be described with respect to particular embodiments and with reference to certain drawings but the invention is not limited thereto but only by the claims. Any reference signs in the claims shall not be construed as limiting the scope of the invention. The drawings described are only schematic and are nonlimiting. In the drawings, the size of some of the elements may be exaggerated and not drawn on scale for illustrative purposes.
The terms first, second, third and the like in the description and in the claims, are used for distinguishing between similar elements and not necessarily for describing a sequential or chronological order. It is to be understood that the terms so used are interchangeable under appropriate circumstances and that the embodiments of the invention described herein are capable of operation in other sequences than described or illustrated herein.
Furthermore, the terms top, bottom, over, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.
Moreover, it is to be understood that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B. Where an indefinite or definite article is used when referring to a singular noun e.g. "a" or "an", "the", this includes a plural of that noun unless something else is specifically stated.
By way of introduction to the embodiments, some known structures will be described. Fig 1 illustrates a MOSFET 100, known from US 2003/0006453. Like a conventional MOSFET, it is formed on a heavily doped n+ semiconductor substrate 102. A more lightly doped epitaxial layer defining drift region 104 is grown on substrate 102. At the top of region 104, p-type body regions 108 are formed. n+ source regions 110 are formed within body regions 108. A gate 106 is formed atop the epitaxial layer across the p-body regions to reach source regions 110, and is insulated therefrom by an oxide layer 112. Metal contacts 114 and 116 are formed for electrical interconnection source regions 110 and substrate 102 to act as source and drain contacts, respectively. Additionally, MOSFET 100 includes sidewall metal-thick-oxide (MTO) dielectric columns 118. Each of dielectric columns 118 extends vertically at the opposite edges of n drift region 104. As such, drift region 104 resembles a column having width 2w. One edge of each dielectric column 118 is adjacent to n drift region 104 of MOSFET 100. The opposite edge of each column 118 is bounded by a vertically extending conductive region 120. Each conductive region 120 is formed of a p+/n+ poly-silicon semiconductor. As well, conductive regions 120 are electrically connected to source metal contact 114.
Functionally, for MOSFET 100 in its off-state, the voltage across each column 118 deposits a charge at the edge of each column 118. This charge, in turn, exerts an electric field on drift region 104 that depletes free carriers in the n column of the drift region 104 laterally. That is, free carriers are redistributed within drift region 104. This alters the original vertical field distribution within the drift region 104 to extend further from the gate. Preferably, the sidewall oxide is thermally grown to obtain the highest breakdown quality, or if any other dielectric material is chosen to replace the oxide, it should have a breakdown field strength equal to or greater than that of the thermal oxide. The dielectric thickness can be controlled.
The specific on-state resistance between drain and source Ron,sp is calculated to be proportion to (w+wMTO)/(Nd*w) where Nd is concentration of dopants, w is the trench column half-width, wMTO is the sum of sidewall oxide thickness and the electrode half-width, welec, that is, wMTO=tₒₓ+welec. It may be shown that an optimal ratio of wMTO to w of 4:3 exists for minimum Ron,sp. The thickness of the bottom oxide dₒₓ can be chosen to be the same as or preferably greater than oxide thickness tₒₓ.
Owing to additional field modulation by lateral depletion, the doping in the drift region 104 can be raised to a value much higher than that permissible in conventional MOSFETs, thus improving the specific on-resistance to breakdown voltage relationship curve for silicon MOSFET 100. In contrast to known ways of increasing breakdown voltage, no precise matching of doping is needed in MOSFET 100. Instead, for a particular drift region width 2w and doping Nd , it is primarily the sidewall thickness of each column 118, tₒₓ, that needs to be controlled to provide the optimal field effect to deplete the column of the n drift region 104 entirely during the off-state. As oxide thickness control technology is well-known, MOSFET 100 can be manufactured more easily and precisely than known charge compensation structures that require the difficult task of precise doping control and multiple epitaxial growth.
Fig 2(a) shows Oxide Recessed VDMOS which can be compared with the UMOSFET structure of Fig 2(b). These figures are taken from "Temperature characteristics of a new 100V rated power MOSFET, VLMOS (Vertical LOCOS MOS)", Masahito Kodama et al, Proceedings of 2004 International Symposium on Power Semiconductor Devices & ICs, Kitakyushu, pp. 463-466. In Fig 2(b) there is a buried drain region N+, below a drift region N-. A P region is located at the surface. A pair of trench gates are each surrounded by surface source regions N+, and reach down through the P region to the N- drift region.
Fig 2(a) shows a VLMOS structure similar to that of Fig 2(b) except for the following the trench gates are much deeper, reaching through to the drain. Local oxidation of silicon (LOCOS) is used so that each trench gate has a thick insulator facing the drift region, and thin insulation adjacent to the channel. An additional N layer is provided above the drain. A distance between the trench gates and an impurity concentration of the drift region are set to values such that the drift region enclosed by the trench gates is fully depleted by the trench gates during the off-state.
Fig 3 shows a vertical field effect semiconductor, known from US 6,600,192. An n-type SiC drift layer 2 of a low impurity density of the thickness of approximately 60µm is formed on an n-type SiC drain region 1 of a high impurity density of the thickness approximately 300 µm. An n-type SiC source region 4 which is-connected to the source electrode 12 is 0.2 µm in thickness. The thickness of the gate insulating film 8 is 0.10 µm. The optimal value of the thickness of the p+-type SiC buried gate region 5 is 0.3 µm. The optimal thickness of an n-type channel region 3 is 0.3 µm. The width of the p+-type buried gate region 5 is preferably longer than the n-type source region 4 by approximately 5 µm. The gap between the p+-type buried gate region 5 and the p+-type buried gate contact region 6 is optimal at the value of 3 µm. The gate electrode 13 is in a stripe shape which is elongate in the direction normal to the page.

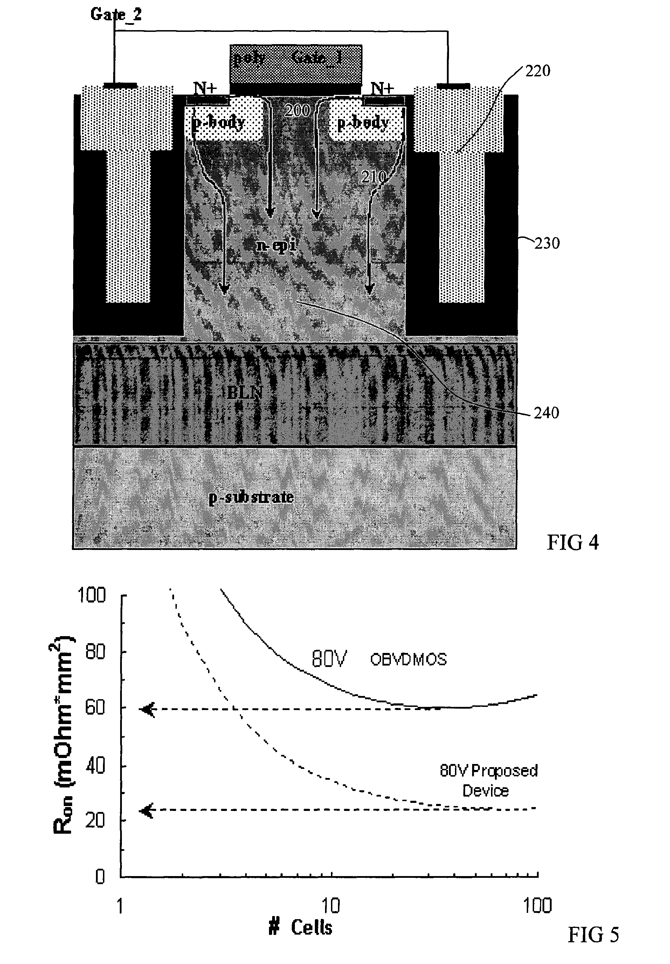

The present invention will now be described mainly with respect to MOS transistors. However the present invention is applicable to other types, e.g. HV BIPOLAR. Also the present invention will mainly be described with respect to NMOS, PMOS, depending upon the conductivity type of the drift region. One example of a manufacturing process for the field effect transistor of the present embodiment is as follows. A suitable semiconductor substrate is provided. This can be doped with either n or p dopants. In the following the present invention will mainly be described with reference to n-type substrate.
For example, a main or power electrode region is formed in a substrate of a first conductivity type, e.g. an n-type SiC substrate of a high impurity density of 10¹⁸ to 10²⁰ atm/cm³ which functions as, e.g. the drain region 1, and, on one of the surfaces thereof, a drift layer of the first conductivity type, e.g. an n-type SiC drift layer 2 of a low impurity density of 10¹⁴ to 10¹⁶ atm/cm³ is formed by a chemical vapor deposition method, or the like. P- and n-type layers and regions are interchangeable provided the function and conductivity types are respected, e.g. if a p-type substrate is used a p-type drift region is required.
Next, a buried control electrode region of a second conductivity type, e.g. a p+-type buried gate region 5 of approximately 10¹⁸ atm/cm³ and a contact region of the second conductivity type such as a p+-type buried gate contact region 6 are formed by an ion implantation of aluminum, or the like, and, on top thereof, a channel region 3 of an n-type SiC drift layer of a low impurity density of 10¹⁴ to 10¹⁶ atm/cm³ is formed again thereon by a chemical vapor deposition method, or the like. Subsequently, at both end parts of the channel region 3, a control electrode region of the second conductivity type, e.g. a p+-type gate contact region 7 which reaches to the p+-type buried gate contact region 6 is formed by an ion implantation method of aluminum, or the like.
Next, a further main or power electrode region of the first conductivity type, e.g. an n-type source region 4 of a high impurity density of 10¹⁸ to 10²⁰ atm/cm³ is formed in the central part of the channel region 3 by an ion implantation method of nitrogen, or the like. After forming an insulating film 8, e.g. of SiO₂, on the channel region 3, the n-type source region 4 and the p-type gate contact region 7, the SiO₂ insulating film 8 is removed from both end parts of the p+-type gate contact region 7, and a control electrode, e.g. gate electrode 13 which is connected to the p-type gate contact region 7 is formed by a metal film, e.g. of Al, or the like. In addition, the SiO₂ insulating film 8 on the central part of the n-type source region 4 is removed and a further main electrode, e.g. source electrode 12, which is connected to the n-type source region 4, is formed of conductive material, e.g. by a metal film such as aluminum or nickel. Furthermore, a portion of the buried gate region 5 is exposed at one position in the depth direction of the segment, and an electrode G1 is connected to the exposed buried gate region 5 so as to be lead out to the side of the source electrode 12. Finally, a main electrode, e.g. a drain electrode 11, which is connected to the drain region 1, is formed by a conductive material, e.g. a metal such as aluminum, nickel, or the like.
According to this configuration, when a voltage equal to or below the built-in voltage of the junction is applied to the control electrode, e.g. gate electrode at the ON-state, the depletion layer expanding into the above-mentioned channel region contracts into a narrow range of the channel region. Therefore, the channel width through which a current flows becomes wide so that a lower ON-state resistance is realizable at a low gate voltage.
At the OFF-state, a depletion layer expands from the junction of the buried gate region as well as the buried gate contact region of the second conductive type and the drift layer, to the side of the drain so as to pinch off the area between both of the buried regions and support a voltage and, therefore, a high electric field is not applied to the gate insulating film and a semiconductor device of a high reliability is obtainable.
In addition, in an area between the buried gate region of the second conductive type and the buried gate contact region of the second conductive type, in order to maintain the ON-state resistance at a low value and to reduce the gate resistance, buried gate connection regions of the second conductive type are formed being spaced with predetermined intervals from each other. Thereby, the three regions of the second conductive type are electrically connected.
By this structure, the depletion layer expanding through the channel region can be made to contract to a narrow range, not only in the upward and downward directions but also in all directions, by applying a voltage equal to the built-in voltage and below to the gate. As a result, the channel width can be wide, and a low ON-state resistance is realizable even in a low gate voltage. In addition, the normally off condition can be easily implemented and a higher withstand voltage can be achieved.
Since the control electrode, e.g. the gate, is divided into an insulated control electrode, e.g. a MOS insulated gate and a buried control electrode, e.g. a buried gate, respective gates can be controlled independently. When a voltage that is higher than that to the buried gate is applied to the MOS insulated gate, a further large storage effect of carriers can be attained so that the ON-state resistance can be further lowered. By applying a voltage equal to the built-in voltage or higher to the gate, holes are injected to the channel region from the buried gate of the second conductive type so as to conductivity-modulate layer of the first conductive type, and the ON-state resistance can be further reduced. Figure 4 shows an embodiment, which can make use of some of the techniques described above. This shows a structure having two channels 200, 210 on each side of the device. The ON-resistance of the power device is reduced by using two channels in parallel. Notably this reduction can be achieved without increasing the cell size. The second channel 210 is a predominantly vertical one, the first channel 200 is a horizontal one. The structure is symmetrical though in principle, one side only of the structure could be used. A first conductive control electrode layer, e.g. a first gate 1 (polysilicon) is located above the first channel to control it. A first main electrode region of a first conductivity type, e.g. a source N+ region in a body of a second conductivity type, e.g. a p-body, is provided on either side of the first control electrode, e.g. gate. Below the source and first gate is a drift region 240 of n-epi. On each side of the drift region is a deep trench structure having a conductive part 220 and insulator 230. This can be constructed as described above.
The illustration in figure 4 represents one unit cell of the device. Both vertical and horizontal channels feed into a vertical drift region. The buried layer or the substrate of the first conductivity type, e.g. a n-type buried layer or BLN is used to collect the drain current, i.e. from the second main electrode region, e.g. the drain electrode region. The device can be formed on a substrate of a second conductivity type, e.g. a p-substrate as shown, if a sinker (not shown) is used to contact the BLN with the second main electrode, e.g. drain electrode. The device can double the maximum current density for a given reverse blocking voltage, i.e. the ON resistance can be reduced by a factor 2. The structure can use parts of the known examples set out above and use manufacturing steps described above. Many variations can be envisaged and are included within the scope of the present invention. Some of the advantages of multiple channels can be achieved even without the combination of horizontal and lateral channels, or without the symmetry, or with shallower trench gates for example. Multi cell devices can have an arrangement of cells, each having a device as shown in figure 4. Various arrangements of the cells can be envisaged, following established principles.
Figure 5 shows a graph of ON resistance versus number of cells. This compares the (simulated) ON resistances achieved with the embodiment of fig 5, and with an Oxide bypassed VDMOS in function of the number of unit cells in the device. Both devices have a V_{bd} of 80V. As can be seen, the ON resistance drops gradually to around 60 mOhm.mm² for the OBVDMOS, while it drops to a value of less than 25 for the embodiment.
As has been described above, a multi cell power semiconductor device has a control electrode, e.g. a gate (e.g. polysilicon, 220), a first main electrode region of a first conductivity type, e.g. a source region (n+) and a second main electrode region, e.g. a drain region (BLN), a drift region (240) between the source and drain, and two or more channel regions (200, 210) arranged to allow current flow in parallel between the source and drain. Two channel regions arranged so that current flow is in parallel helps to allow a greater maximum current density for a given reverse blocking voltage, so ON resistance can be reduced, without decreasing the reverse breakdown voltage. One channel can be vertical, and one can be predominantly lateral, to enable better integration. The gate region can be a deep trench structure. The device can be symmetrical having a pair of first main electrode regions, e.g. source regions, and a pair of second control electrode regions, e.g. second gate regions, and a pair of lateral channels and a pair of vertical channels. Other variations can be envisaged within the scope of the claims. For example, the semiconductor device can include any suitable transistor, e.g. a MOS type such as MOSFET, a HV bipolar transistor, etc. For an HV bipolar transistor the gate 1 is replaced by a base contact. For a bipolar transistor the n+ region in the p-body described in the above embodiments is replaced by a p+ region constituting the base contact. Drain is then replaced with an emitter. In this way, a HV bipolar with low collector resistance is obtained, i.e. high doping level of the drift region is the collector region. Gate 2 should be off and hence gate 2 is to be connected to the emitter. If gate 2 is to be separately biased, a combined MOS/bipolar transistor can be used, e.g. for applications such as ESD.

## Claims

1. A semiconductor device comprising a control electrode, a first main electrode region and a second main electrode region, a drift region between the first and second main electrode regions, and two or more channel regions arranged to allow current flow in parallel between the first and second main electrode regions.

2. The device of claim 1, a first of the channels being predominantly lateral, and a second being predominantly vertical.

3. The device of claim 1 or 2, the control electrode comprising first and second control electrode regions for each of the channels.

4. The device of claim 3, the first and second control electrode regions being separately controllable.

5. The device of claim 3 or 4, the second control electrode region comprising a deep trench structure.

6. The device of claim 3, 4 or 5, the first control electrode region comprising a surface control electrode structure.

7. The device of any preceding claim when depending on claim 3, the first main electrode region being arranged in between the first and second control electrode regions.

8. The device of any preceding claim when depending on claim, having a symmetrical structure about the first control electrode region, having a pair of first main electrode regions, and a pair of second control electrode regions, and a pair of lateral channels and a pair of vertical channels.

9. The device of any preceding claim, the drift region being arranged as a vertical common drift region coupled to all the channels.

10. The device according to any previous claim wherein a main electrode contact is at the bottom of the structure or can be a BLN that is contacted to a top semiconductor layer via a sinker.

11. The device of any preceding claim wherein the thickness of insulation for a control electrode and/or the work function of the control electrode material for the two or more channels are substantially equal.

12. A multi cell semiconductor device having many unit cells, each unit cell comprising the device of any preceding claim.

## Amended claims

### Amended claims in accordance with Rule 86(2) EPC.

**1.** A semiconductor device comprising a control electrode (7), a first main electrode region (4) and a second main electrode region (11), a drift region (240) between the first and second main electrode regions, and two or more channel regions arranged to allow current flow in parallel between the first and second main electrode regions, a first of the channels (200) being predominantly lateral, and a second (210) being predominantly vertical, the first of the channels having a threshold voltage lower than a threshold voltage of the second of the channels.

**2.** The device of claim 1, the control electrode comprising first and second control electrode regions (1,2) for each of the channels.

**3.** The device of claim 2, the first and second control electrode regions being separately controllable.

**4.** The device of claim 2 or 3, the second control electrode region comprising a deep trench structure (220, 230).

**5.** The device of claim 2, 3, or 4, the first control electrode region comprising a surface control electrode structure.

**6.** The device of any preceding claim when depending on claim 2, the first main electrode region being arranged in between the first and second control electrode regions.

**7.** The device of any preceding claim when depending on claim 2, having a symmetrical structure about the first control electrode region, having a pair of first main electrode regions, and a pair of second control electrode regions, and a pair of lateral channels and a pair of vertical channels.

**8.** The device of any preceding claim, the drift region being arranged as a vertical common drift region coupled to all the channels.

**9.** The device according to any previous claim wherein a main electrode contact is at the bottom of the structure or can be a buried layer (BLN) that is contacted to a top semiconductor layer via a sinker.

**10.** The device of any preceding claim wherein the thickness of insulation for a control electrode or the work function of the control electrode material for the two or more channels are substantially equal.

**11.** A multi cell semiconductor device having many unit cells, each unit cell comprising the device of any preceding claim.
